# EUROPÄISCHE PATENTSCHRIFT

(11) **EP 1 487 759 B1**
(45) Veröffentlichungstag und Bekanntmachung des Hinweises auf die Patenterteilung: **23.05.2007**
(21) Anmeldenummer: 03718617.8
(22) Anmeldetag: 06.03.2003
(51) Int. Cl.: C04B 37/02, H05K 3/38

(54) **VERFAHREN ZUM HERSTELLEN EINES METAL-KERAMIK-SUBTRATS, VORZUGSWEISE EINES KUPFER-KERAMIK-SUBSTRATS**
METHOD FOR THE PRODUCTION OF A METAL-CERAMIC SUBSTRATE, PREFERABLY A COPPER-CERAMIC SUBSTRATE
PROCEDE POUR LA PRODUCTION D'UN SUBSTRAT METAL-CERAMIQUE, DE PREFERENCE D'UN SUBSTRAT CUIVRE-CERAMIQUE

(30) Priorität: 13.03.2002 DE 10211266; 21.03.2002 DE 10212495
(43) Veröffentlichungstag der Anmeldung: 22.12.2004
(73) Patentinhaber: Electrovac AG, 3400 Klosterneuburg (AT)
(72) Erfinder: Dr.-Ing. Jürgen Schulz-Harder, 91207 Lauf (DE)
(74) Vertreter: Graf, Helmut
(86) Internationale Anmeldenummer: PCT/DE2003/000708
(87) Internationale Veröffentlichungsnummer: WO 2003/078353

(56) Entgegenhaltungen:
- EP-A- 0 862 209
- DE-A- 4 338 706
- US-A- 5 981 036

## Beschreibung

Die Erfindung bezieht sich auf ein Verfahren gemäß Oberbegriff Patentanspruch 1.

Die Herstellung von Metall-Keramik-Substraten und dabei insbesondere von Kupfer-Keramik-Substraten für elektrische Schaltungen und Schaltkreise ist in unterschiedlichsten Varianten bekannt. Bekannt ist hierbei speziell auch, die zum Herstellen von Leiterbahnen, Anschlüssen usw. benötigte Metallisierung auf einer Keramik, z.B. auf einer Aluminium-Oxid-Keramik mit Hilfe des sogenannten "DCB-Verfahrens" (Direct-Copper-Bond-Technology) herzustellen, und zwar unter Verwendung von die Metallisierung bildenden Metall- bzw. Kupferfolien oder Metall- bzw. Kupferblechen, die an ihren Oberflächenseiten eine Schicht oder einen Überzug (Aufschmelzschicht) aus einer chemischen Verbindung aus dem Metall und einem reaktiven Gas , bevorzugt Sauerstoff aufweisen. Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht. Dieses DCB-Verfahren weist dann z.B. folgende Verfahrensschritte auf:
- Oxidieren einer Kupferfolie derart, dass sich eine gleichmäßige Kupferoxidschicht ergibt;
- Auflegen der Kupferfolie auf die Keramikschicht;
- Erhitzen des Verbundes auf eine Prozesstemperatur zwischen etwa 1025 bis 1083°C, z.B. auf ca. 1071 °C;
- Abkühlen auf Raumtemperatur.

Nach dem Aufbringen der Metall-Folien erfolgt zumindest an einer Oberflächenseite der Keramikschicht das Strukturieren der dortigen Metallfolie, z.B. Kupferfolie (auch DCB-Kupfer) zur Bildung von Leiterbahnen, Kontaktflächen usw..

Bekannt ist weiterhin das sogenannte Aktivlot-Verfahren (DE 22 13 115; EP-A-153 618), speziell auch zum Herstellen von Metall-Keramik-Substraten. Bei diesem Verfahren wird bei einer Temperatur zwischen ca. 800 - 1000°C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Cr ist, stellt durch chemische Reaktion eine Verbindung zwischen dem Lot und der Keramik her, während die Verbindung zwischen dem Lot und dem Metall eine metallische Hartlöt-Verbindung ist.

Speziell bei der Herstellung von Metall-Keramik-Substraten ist bekannt (EP 0 862 209 A2), auf beide Oberflächenseiten einer Keramikschicht jeweils eine Metallisierung aufzubringen, und zwar eine erste Metallisierung in Form einer Kupferfolie unter Verwendung des DCB-Prozesses auf die eine Oberflächenseite und eine zweite Metallisierung in Dickfilm- oder Dünnfilmtechnik auf die andere Oberflächenseite. Das Aufbringen der Metallisierungen, von denen die zweite Metallisierung an in der Keramikschicht vorgesehenen Öffnungen auch durch Kontaktierungen bildet, erfolgt in zwei getrennten Verfahrensschritten, und zwar beispielsweise zunächst das Aufbringen der ersten Metallisierung unter Verwendung des DCB-Prozesses und dann in einem weiteren Verfahrensschritt das Aufbringen der zweiten Metallisierung in Dickfilm- oder Dünnfilmtechnik.

Die Herstellung der Metall-Keramik-Substrate erfolgt vorzugsweise im Mehrfachnutzen derart, dass auf einem großflächigen Keramiksubstrat mehrere Einzelsubstrate voneinander beabstandet gebildet werden, die dann jeweils die Leiterbahnen, Kontaktflächen usw. aufweisen. An Sollbruchlinien, die vorzugsweise mittels eines Lasers in das Keramiksubstrat eingebracht werden, kann dieser Mehrfachnutzen dann später z.B. nach dem Bestücken durch Brechen in die Einzelsubstrate zertrennt werden.

Aufgabe der Erfindung ist es, ein Verfahren aufzuzeigen, mit dem die Herstellung von Metall-Keramik-Substraten mit verbesserten Eigenschaften auf einfache Weise möglich ist. Zur Lösung dieser Aufgabe ist ein Verfahren entsprechend dem Patentanspruch 1 ausgebildet.

Ein Hochtemperatur-Bonding-Verfahren gemäß der Erfindung ist ein Verfahren, mit dem bei einer Temperatur größer als 650°C eine Verbindung zwischen der jeweiligen Metallfolie und dem Keramiksubstrat oder der Keramikschicht hergestellt wird. Ein Hochtemperatur-Bonding-Verfahren ist also das vorstehend beschriebene Direct-Bonding-Verfahren und bei Verwendung von Kupfer das vorstehend beschriebene DCB-Verfahren. Ein Hochtemperatur-Bonding-Verfahren im Sinne der Erfindung ist aber auch das vorstehend beschriebene Aktivlötverfahren.

Es hat sich gezeigt, daß in überraschender Weise bei Metallisierungen, die mit einem Hochtemperatur-Bonding-Verfahren auf das Keramiksubstrat aufgebracht sind, eine besonders zuverlässige Haftung des Lötstopplacks erzielt wird. Dies ist nach einer der Erfindung zugrundeliegenden Erkenntnis offenbar auf die Kornvergrößerung der Material-Struktur der Metallisierungen zurückzuführen, die (Kornvergrößerung) bei dem Hochtemperatur-Bonding-Verfahren eintritt.

Bei der Erfindung erfolgt das Aufbringen des wenigstens einen Auftrags aus Lötstopplack (Lötstopplack-Auftrag) z.B. unmittelbar nach dem Strukturieren der betreffenden Metallisierung, gegebenenfalls nach einem Zwischenreinigen. Hierdurch ist ein eventuelles, das Anhaften des Lötstopplacks beeinträchtigendes Verschmutzen der Metalloberflächen vor dem Aufbringen des wenigstens einen Lötstopplack-Auftrags vermieden. Es hat sich hierbei auch in überraschender Weise gezeigt, daß bei Metalloberflächen, die von DCB-Kupfer gebildet sind, die besonders zuverlässige Haftung des Lötstopplacks erzielt und eine Unterwanderung des Lötstopplacks beim Löten wirksam verhindert ist, obwohl die mittels des DCB-Verfahrens aufgebrachte Kupfer-Metallisierung einen erhöhten Anteil an Sauerstoff enthält.

Bei dem erfindungsgemäßen Verfahren ist es weiterhin auch möglich, daß der Lötstopplack bereits vor dem Strukturieren der betreffenden Metallisierung auf diese aufgebracht wird. Wird für das Strukturieren der Metallisierung die übliche Ätz- und Maskierungstechnik verwendet, bei der ein Ätzresist z.B. in Form eines Foto- oder Siebdrucklacks aufgebracht wird, so wird für den Lötstopplack ein Lack verwendet, der gegenüber den üblichen Mitteln, die zum Ätzen und/oder Entfernen der Maskierung aus dem Ätzresist verwendet werden, insbesondere gegenüber den hier üblicherweise verwendeten alkalischen Lösungen resistent ist. Als Lötstopplack eignet sich hierbei insbesondere ein Lack auf Epoxi-Harz-Basis.

Vorstehend wurde davon ausgegangen, daß bei dem erfindungsgemäßen Verfahren das Aufbringen der Metallisierungen auf das Keramik-Substrat mit Hilfe der Direct-Bonding-Technik erfolgt. Selbstverständlich sind bei der Erfindung auch andere Hochtemperatur-Bonding-Verfahren oder Techniken anwendbar, beispielsweise das Aktivlötverfahren.

Erfolgt eine Herstellung der Metall-Keramik-Substrate im Mehrfachnutzen, wie dies bevorzugt der Fall ist, so wird der Lötstopplack aufgebracht, bevor die Sollbruchlinien in das Keramik-Substrat eingebracht werden, also bevor eine das Anhaften des Lötstopplacks beeinträchtigende Oxidation und/oder Verschmutzung der Metallflächen, beispielsweise durch Laser-Plasma beim Einbringen der Sollbruchlinien eintreten könnte.

In Weiterbildung des erfindungsgemäßen Verfahrens bestehen u.a. auch folgende Möglichkeiten, die auch in beliebigen Kombinationen verwendet werden können und
dadurch gekennzeichnet sind,
daß Hochtemperatur-Bonding bei einer Temperatur größer 650°C durchgeführt wird,
und/oder
daß Hochtemperatur-Bonding ein Direct-Bonding-Verfahren ist,
und/oder
daß Hochtemperatur-Bonding ein Aktiv-Löt-Verfahren ist,
und/oder
daß der wenigstens eine Auftrag aus dem Lötstopplack vor dem Strukturieren aufgebracht wird,
und/oder
daß der wenigstens eine Auftrag aus dem Lötstopplack nach dem Strukturieren aufgebracht wird,
und/oder
daß die Metall-Folien Kupfer-Folien sind und diese mittels des DCB-Verfahrens oder des Aktiv-Löt-Verfahrens auf dem Keramik-Substrat vorgesehen werden,
und/oder
daß die Strukturierung der wenigstens einen Metall-Folie mittels eines Maskierungs-Ätz-Verfahrens erfolgt und das Aufbringen des wenigstens einen Auftrags aus Lötstopplack unmittelbar nach diesem Strukturieren erfolgt,
und/oder
daß die Strukturierung der wenigstens einen Metall-Folie mittels eines Maskierungs-Ätz-Verfahrens unter Verwendung eines Ätzresists erfolgt daß das Aufbringen des wenigstens einen Auftrags aus Lötstopplack unmittelbar vor dem Aufbringen des Ätzresists erfolgt,
und/oder
daß nach dem Aufbringen des Lötstopplack-Auftrags ein Abtragen des Metalls der Metallisierung zumindest in an diesen Lötstopplack-Auftrag angrenzenden Oberflächenbereichen erfolgt,
und/oder
daß das Abtragen durch Ätzen erfolgt, beispielsweise unter Verwendung von Wasserstoffperoxid, Natriumpersulfat, Kupferchlorid oder Eisenchlorid,
und/oder
daß das Abtragen mit einer Dicke von 0,1 bis 20 µm erfolgt,
und/oder
daß vor dem Aufbringen des wenigstens einen Lötstopplack-Auftrags eine Reinigung der Metallflächen, vorzugsweise durch Abtragen eines Oberflächenbereichs der Metallisierungen erfolgt,
und/oder
daß das Reinigen durch chemisches Abtragen und/oder durch Plasma-Ätzen und/oder durch elektrisches Ätzen und/oder galvanisches Abtragen und/oder durch mechanische Bearbeitung, beispielsweise durch Bürsten oder Schleifen erfolgt,
und/oder
daß das chemische Reinigen unter Verwendung einer Wasserstoffperoxid-Lösung oder einer Natriumpersulfat-Lösung erfolgt,
und/oder
daß auf wenigstens einen an den wenigstens einen Lötstopplack-Auftrag anschließenden, vorzugsweise durch Abtragen erzeugten Oberflächenbereich zumindest einer Metallisierung eine Oberflächen-Metallisierung aufgebracht wird,
und/oder
daß das Aufbringen der Oberflächen-Metallisierung derart erfolgt, daß die von dieser Oberflächen-Metallisierung gebildete Oberfläche niveaugleich oder in etwa niveaugleich mit der Oberfläche des wenigstens einen Lötstopplack-Auftrags oder niveaugleich oder in etwa niveaugleich mit der unbehandelten Oberfläche unterhalb des wenigstens einen Lötstopplack-Auftrags ist,
und/oder
daß das Aufbringen der Oberflächen-Metallisierung derart erfolgt, daß die von dieser Oberflächen-Metallisierung gebildete Oberfläche über das Oberflächenniveau des wenigstens einen Lötstopplack-Auftrags oder über das Oberflächenniveau der unbehandelten Oberfläche unterhalb des wenigstens einen Lötstopplack-Auftrags vorsteht,
und/oder
daß das Aufbringen der Oberflächen-Metallisierung derart erfolgt, daß die von dieser Oberflächen-Metallisierung gebildete Oberfläche etwas tiefer liegt als das Oberflächenniveau des wenigstens einen Lötstopplack-Auftrags oder der unbehandelten Oberfläche unterhalb des wenigstens einen Lötstopplack-Auftrags,
und/oder
daß für den Lötstopplack-Auftrag ein Lack auf Epoxid-Basis verwendet wird, und daß das Aushärten des Lötstopplack-Auftrags thermisch erfolgt,
und/oder
daß der wenigstens eine Lötstopplack-Auftrag eine Dicke von 0,5 - 100 µm aufweist,
und/oder
daß der wenigstens eine Lötstopplack-Auftrag zumindest in einem Bereich zur Bildung eines optisch lesbaren Codes strukturiert wird.

Weiterbildungen der Erfindung sind Gegenstand der Unteransprüche. Die Erfindung wird im Folgenden anhand der Figuren an verschiedenen Ausführungsformen näher erläutert. Es zeigen:
- Fig. 1: in vereinfachter Darstellung und im Schnitt ein nach dem erfindungsgemäßen Verfahren hergestelltes Kupfer-Keramik-Substrat;
- Fig. 2: in Positionen a - d die verschiedenen Verfahrensschritte bei einer möglichen Ausführungsform des erfindungsgemäßen Verfahrens zum Herstellen des Substrats der Fig. 1;
- Fig. 3: in vergrößerter Darstellung einen Teilschnitt durch ein nach dem erfindungsgemäßen Verfahren hergestelltes Substrat im Bereich eines Lötstopp-Lackauftrags nach einem Abtragen des Metalls der angrenzenden Metalloberfläche;

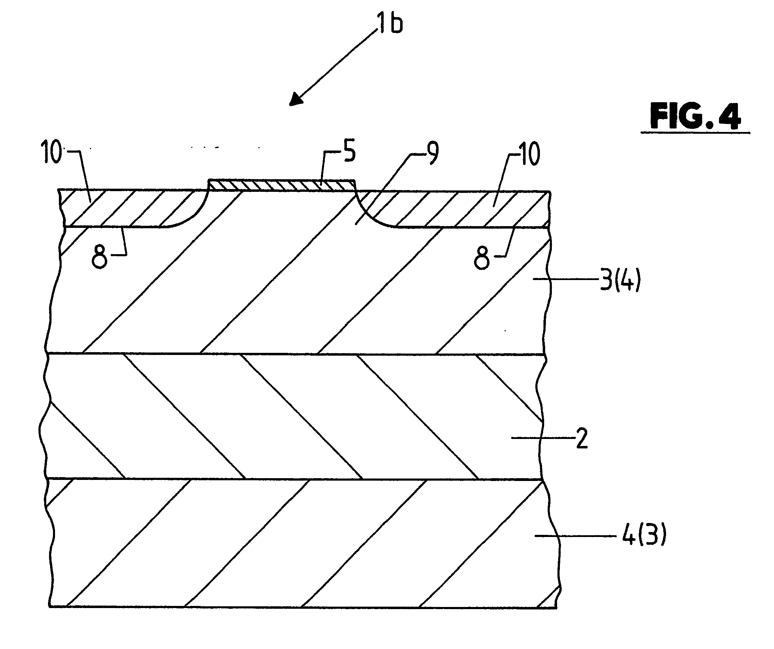

- Fig. 4: eine Darstellung ähnlich Figur 3, jedoch bei einer nachträglichen Metallisierung;
- Fig. 5: eine Darstellung ähnlich Figur 3, jedoch bei strukturiertem Lötstopp-Lackauftrag;
- Fig. 6: eine Draufsicht auf den strukturierten Lötstopp-Lackauftrag.;
- Fig. 7: eine Darstellung wie Figur 2 bei einer weiteren Ausführung des erfindungsgemäßen Verfahrens.

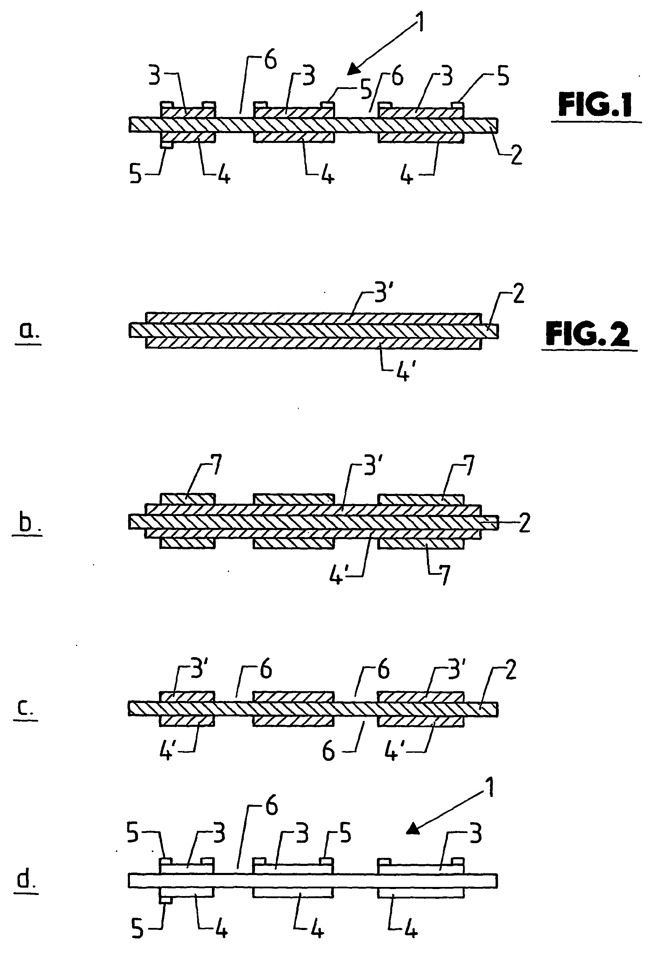

In den Figuren 1 und 2 ist 1 ein Keramik-Kupfer-Substrat bestehend aus der Keramikschicht 2 und den an den beiden Oberflächenseiten der Keramikschicht 2 vorgesehenen Metallisierungen 3 und 4, die zur Bildung von Leiterbahnen, Kontaktflächen usw. in der erforderlichen Weise strukturiert sind und aus Kupfer bestehen. In bestimmten Bereichen der Metallisierungen 3 und 4 sind Lötstopplack-Aufträge 5 aufgebracht, die z.B. streifenförmig ausgebildet sind, aber auch einen anderen Verlauf aufweisen können und die beim Bestücken des Substrats 1 mit Bauelementen denjenigen Bereich der Metallisierung 3 bzw. 4 begrenzen, der von dem verwendeten Lot benetzt werden soll. Mit den Aufträgen 5, die sich beispielsweise entlang der Ränder der durch die Strukturierung erzeugten Kontaktflächen und Leiterbahnen erstrecken, wird beispielsweise verhindert, daß das beim Bestücken des Substrates 1 verwendete Lot in die zwischen den Leiterbahnen, Kontakte usw. gebildeten und diese elektrisch trennenden Zwischenräume 6 fließt und zu Kurzschlüssen zwischen den Leiterbahnen führt.

Hergestellt wird das Substrat 1 mit den in der Figur 2 dargestellten Verfahrensschritten, d. h. zunächst werden auf die Keramikschicht 2 Kupferfolien 3' bzw. 4' mit Hilfe der DCB-Technik aufgebracht, so daß diese Kupferfolien 3' und 4' auf ihrer gesamten Fläche mit jeweils einer Oberflächenseite der Keramikschicht 2 verbunden sind.

Im Anschluß daran erfolgt entsprechend den Schritten b) und c) der Figur 2 das Strukturieren der Kupferfolien 3' und 4' zur Bildung der strukturierten Metallisierungen 3 und 4, und zwar mit der üblichen Ätz- und Maskierungstechnik durch Aufbringen einer Maskierung 7 aus einem Fotolack oder Ätzresist und anschließendes Wegätzen der durch die Maske 7 nicht abgedeckten Bereiche der Kupferfolien 3' und 4' (Position b), so daß schließlich nach dem Entfernen der Maskierung 7 das in der Position c dargestellte Zwischenprodukt erhalten ist, und zwar bestehend aus der Keramikschicht 2 und den strukturierten Metallisierungen 3 und 4. In einem anschließenden Verfahrensschritt werden die Lötstopplack-Aufträge 5 hergestellt, und zwar beispielsweise durch ein Siebdruckverfahren, so daß schließlich das in der Position d nochmals dargestellte Substrat 1 erhalten ist.

Die Lötstopplack-Aufträge 5 erfolgen mit einer solchen Dicke, daß diese Aufträge 5 nach dem Aushärten des Lötstopplacks eine Dicke von 0,5 bis 100 µm aufweisen. Als Lötstopplack wird beispielsweise ein Lack auf Epoxid-Basis verwendet. Die Aushärtung des Lötstopplacks erfolgt durch Erhitzen.

Es hat sich gezeigt, daß bei einem Aufbringen des Lötstopplacks unmittelbar nach dem DCB-Prozess oder unmittelbar nach Abschluß der Strukturierung der Kupferfolien 3' bzw. 4' durch die Ätz- und Maskierungstechnik ein optimales Anhaften des Lötstopplacks an den Kupferfolien erreicht ist und insbesondere auch ein Unterwandern des Lötstopplack-Auftrags durch das Lot beim späteren Bestücken des Substrats 1 wirksam verhindert ist, ohne daß grundsätzlich die Notwendigkeit einer Reinigung der Metalloberflächen vor dem Aufbringen des Lötstopplacks besteht.

Bei dem beschriebenen Verfahren besteht aber auch die Möglichkeit, die Oberflächen der Metallisierungen 3 und 4 nach dem Strukturieren zusätzlich zu reinigen. Für diese zusätzliche Reinigung oder Zwischenreinigung sind unterschiedlichste Reinigungsverfahren denkbar, beispielsweise auch durch Abtragen eines Oberflächenbereichs der Metallisierungen 3 und 4. Speziell hierfür kann ein chemisches Verfahren verwendet werden, und zwar durch Anwenden einer sauren Wasserstoffperoxid-Lösung oder einer sauren Natriumpersulfat-Lösung. Weiterhin ist auch eine Zwischenreinigung der Oberflächen der Metallisierungen 3 und 4 durch Plasma-Ätzen und/oder elektrochemisches oder elektrolytisches Ätzen (galvanisches Abtragen von Kupfer) möglich. Ferner können auch rein mechanische Reinigungsverfahren, beispielsweise durch Bürsten, Schleifen oder dergleichen Anwendung finden.

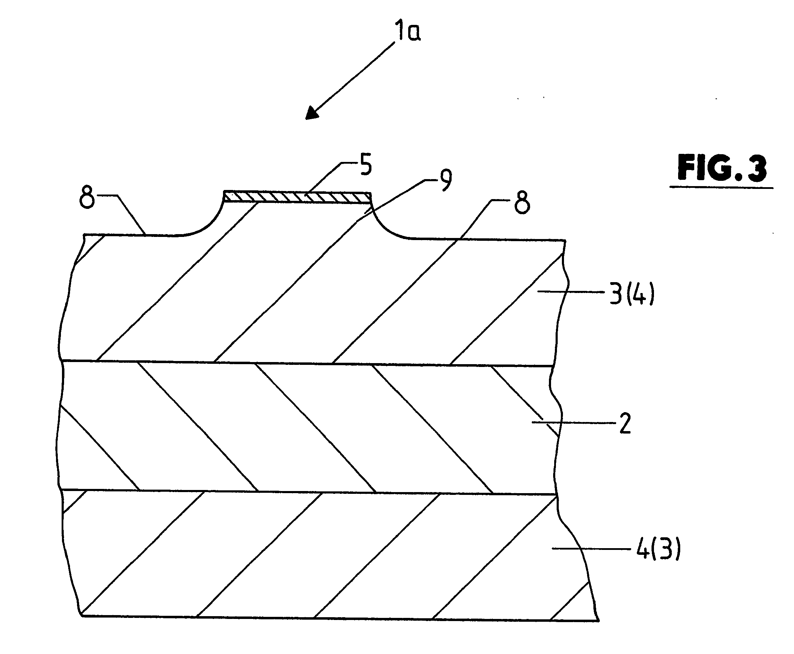

Die Figur 3 zeigt in vergrößerter Darstellung einen Teilschnitt durch ein Kupfer-Keramik-Substrat 1a, bei dem die Metallisierungen 3 bzw. 4 zumindest in Oberflächenbereichen, die an den Lötstopplack-Auftrag 5 angrenzen, durch ein chemisches Ätzverfahren bis zu einer Oberfläche 8 abgetragen sind. Der Lötstopplack-Auftrag 5 dient hierbei als Maskierung beim Ätzen. Als Ätzmittel eignen sich grundsätzlich alle Kupfer auflösenden Mittel, wie z. B. saures Wasserstoffperoxid, saures Natriumpersulfat, Kupferchlorid, Eisenchlorid usw. Der Abtrag erfolgt beispielsweise mit einer Stärke von 0,1 bis 20 µm, so daß sich der Lötstopplack-Auftrag 5 dann auf einem über die durch Abtragen erzeugte Oberfläche 8 vorstehenden Vorsprung 9 befindet. Durch diese Ausbildung kann die Wirkung des Lötstopplack-Auftrages 5 wesentlich verbessert werden.

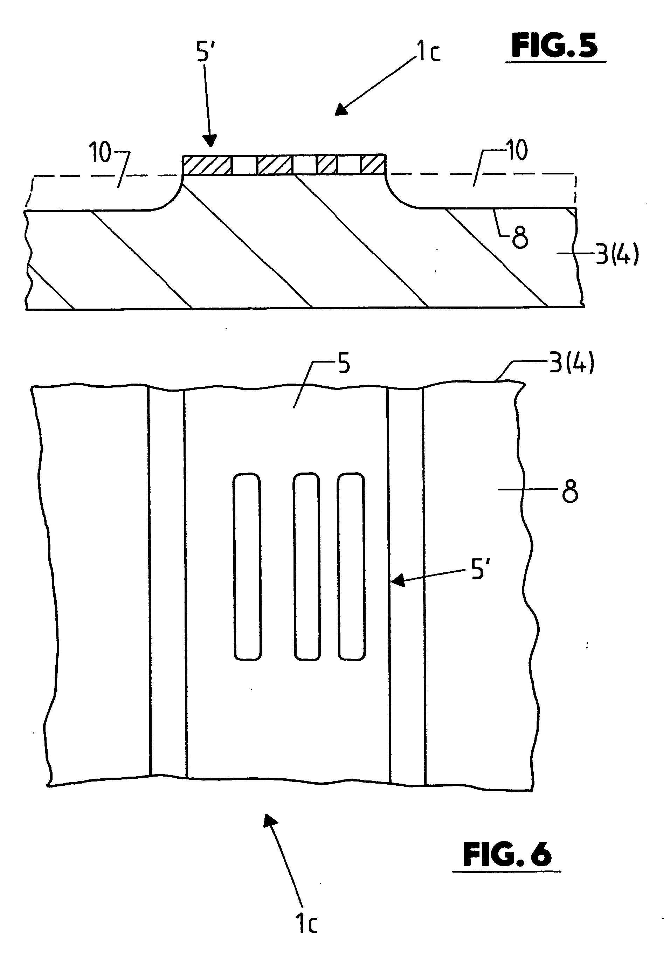

Weiterhin besteht entsprechend der Figur 5 die Möglichkeit, auf die abgetragenen Oberflächenbereiche 8 eine zusätzliche Oberflächen-Metallisierung 10 aufzubringen, die dann mit ihrer Oberflächenseite tiefer oder in einer Ebene mit der nicht abgetragenen, ursprünglichen Oberfläche der Metallisierung 3 bzw. 4 unter dem Lötstopplack-Auftrag 5 liegt. Die Metallisierung 10 bildet beispielsweise eine korrosionsbeständige Metalloberfläche oder generell eine Oberfläche, die eine weitere Verarbeitung dieses Substrats 1b wesentlich verbessert. Als Metall für die zusätzliche Metallisierung 10 eignet sich z. B. Nickel oder Phosphornickel. Das Aufbringen der zusätzlichen Metallisierung 10 erfolgt beispielsweise stromlos durch chemisches Abscheiden.

Grundsätzlich besteht auch die Möglichkeit, die Metallisierung 10 mehrschichtig auszubilden, beispielsweise bestehend aus einer unteren, an die Oberfläche 8 unmittelbar angrenzenden ersten Schicht, z. B. aus Nickel und einer äußeren Schicht aus Gold oder Zinn.

Die Figuren 5 und 6 zeigen als weitere mögliche Ausführungsform ein Substrat 1c, bei dem zumindest ein Lötstopplack-Auftrag 5 in einem Teilbereich 5' mit einer geeigneten Technik derart bearbeitet ist, daß sich an der Oberseite des Substrats in diesem Bereich 5' eine optisch sichtbare Struktur in Form eines Barcodes oder eines Datamatrix-Codes ergibt. Dieser beispielsweise mit einem Kamerasystem lesbare Code enthält dann verschiedene Daten, die das jeweilige Substrat betreffen, die z. B. Artikelnummer, aber auch andere, z.B. für die Überwachung und/oder Steuerung der Produktion notwendige Daten, wie z. B. Herstellungszeitpunkt, Chargennummer usw.

Das Strukturieren des Bereichs 5' erfolgt beispielsweise mittels eines Lasers durch Einbrennen der Struktur oder des Codes in den Lötstopplack-Auftrag 5 oder durch teilweises Wegbrennen des Auftrags 5 für die Struktur.

Bevorzugt werden auch die Substrate 1 - 1c im Mehrfachnutzen hergestellt, d. h. ein entsprechend großes Keramiksubstrat wird zunächst an beiden Oberflächenseiten in der vorbeschriebenen Weise mit den Kupferfolien 3' und 4' versehen und diese werden dann so strukturiert, daß die strukturierten Metallisierungen 3 und 4 nicht nur Leiterbahnen, Kontaktflächen usw. eines Einzel-Kupfer-Keramik-Substrates bilden, sondern eine Vielzahl solcher Einzelsubstrate auf einer gemeinsamen Keramikplatte. Nach dem Strukturieren und vorzugsweise auch nach dem Aufbringen der Lötstopplack-Aufträge 5 erfolgt dann das sogenannte "Laser-Ritzen" des Keramiksubstrats zum Einbringen von Sollbruchlinien, an denen das Mehrfachsubstrat beispielsweise nach dem Bestücken mit Bauelementen in die Einzelsubstrate zerbrochen werden kann. Das Ritzen erfolgt beispielsweise mit einem Laser (z. B. CO₂- oder YAG-Laser). Zum Strukturieren des Bereichs 5' bzw. zum Einbringen des Codes kann dann der zum Ritzen verwendete Laser verwendet werden.

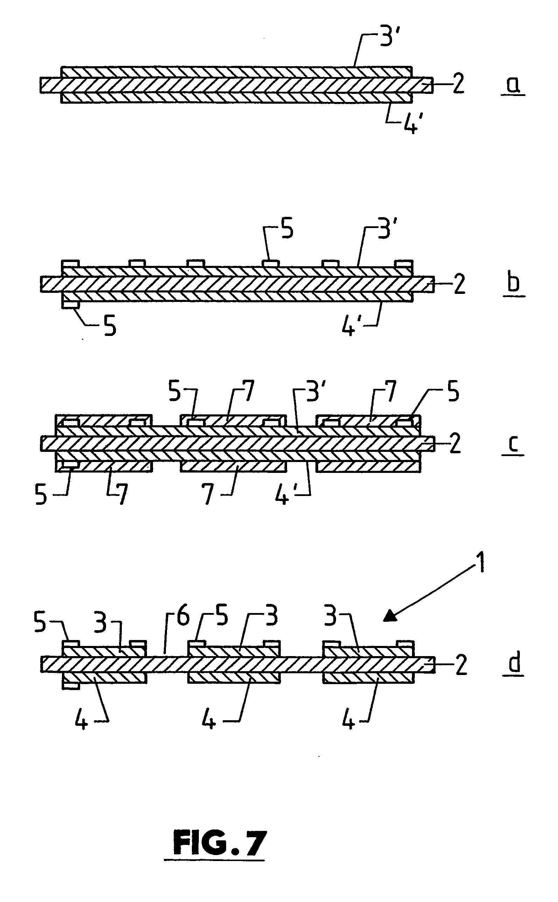

Die Figur 7 zeigt in einer Darstellung ähnlich der Figur 2 die einzelnen Verfahrensschritte zum Herstellen des Keramik-Kupfer-Substrats 1 bei einem gegenüber der Figur 2 modifizierten Herstellungsverfahren. Entsprechend der Position a der Figur 7 wird wiederum auf die Keramikschicht 2 beidseitig jeweils eine Metallfolie 3' bzw. 4' z.B. mit Hilfe der DCB-Technik aufgebracht. Unmittelbar nach diesem Verfahrensschritt und noch vor der Strukturierung der Kupferfolien 3' und 4' erfolgen die Lötstopplack-Aufträge 5 (Position b der Figur 7). In anschließenden Verfahrensschritten c und d erfolgt dann das Strukturieren der Kupferfolien 3' und 4' zur Bildung der strukturierten Metallisierungen 3 und 4, und zwar mit der üblichen Ätz- und Maskierungstechnik durch Aufbringen der Maskierung 7 aus dem Ätzresist, beispielsweise durch einen strukturierten Auftrag des Ätzresists durch eine Drucktechnik (z. B. durch Siebdrucken) oder aber durch eine Fototechnik unter Verwendung von Fotolack und durch anschließendes Wegätzen der durch die Maske 7 nicht abgedeckten Bereiche der Kupferfolien 3' und 4' (Position d), so daß schließlich nach dem Entfernen oder "Strippen" der Maskierung 7 das Kupfer-Keramik-Substrat 1 mit den Lötstopplack-Aufträgen 5 auf den strukturierten Metallisierungen 3 und 4 erhalten ist. Für die Lötstopplack-Aufträge wird ein Lack verwendet, der gegenüber den üblichen, bei der Maskierungs- und Ätztechnik verwendeten Materialien, insbesondere auch gegenüber den zum Entfernen der Maskierung 7 verwendeten Materialien (alkalische Lösungen) resistent ist. Als Lötstopplack eignen sich auch bei dieser Ausführung des erfindungsgemäßen Verfahrens wiederum Lacke auf Epoxi-Harz-Basis.

Es hat sich gezeigt, daß auch bei diesem Verfahren ein besonders zuverlässiges Anhaften des Ätzstopplacks an den Metallfolien 3' und 4' bzw. an den späteren, strukturierten Metallisierungen 3 und 4 erreicht ist, was unter anderem wiederum auf die Kornvergrößerung des Kupfers beim DCB-Prozess zurückzuführen ist.

Die Erfindung wurde voranstehend an verschiedenen Ausführungen beschrieben. Es versteht sich, daß zahlreiche weitere Änderungen sowie Abwandlungen möglich sind, ohne daß dadurch der der Erfindung zugrundeliegende Erfindungsgedanke verlassen wird.

Vorstehend wurde davon ausgegangen, daß das Verbinden der Metallfolien oder Kupferfolien mit der Keramikschicht 2 unter Verwendung des DCB-Verfahrens erfolgt. Grundsätzlich kann auch ein anderes Hochtemperatur-Bonding-Verfahren, z.B. das Aktivlötverfahren Anwendung finden, insbesondere dann, wenn die Keramikschicht 2 z. B. aus einer Aluminiumnitrid-Keramik besteht.

### Bezugszeichenliste

- 1, 1a, 1b, 1c: Kupfer-Keramik-Substrat
- 2: Keramikschicht
- 3, 4: strukturierte Metallisierung
- 3', 4': Kupfer-Folie
- 5: Lötstopplack-Auftrag
- 5': strukturierter Bereich
- 6: Zwischenraum
- 7: Maskierung
- 8: durch Abtragen erzeugte Metall- oder Kupferoberfläche
- 9: Vorsprung
- 10: zusätzliche Oberflächen-Metallisierung

## Patentansprüche

1. Verfahren zum Herstellen eines Metall-Keramik-Substrats, insbesondere Kupfer-Keramik-Substrats, bei dem (Verfahren) auf die Oberflächenseiten einer Keramikschicht oder eines Keramik-Substrats (2) mit Hilfe eines Hochtemperatur-Bonding-Verfahrens jeweils wenigstens eine Metall-Folie (3', 4') aufgebracht wird und die Metall-Folie (3, 4) an wenigstens einer Oberflächenseite zur Bildung von Leiterbahnen, Kontaktflächen und dergleichen strukturiert wird, **dadurch gekennzeichnet, daß** nach dem Hochtemperatur-Bonding-Verfahren auf die Metallfläche wenigstens einer Metallfolie (3', 4') oder wenigstens einer Metallisierung (3, 4, 3', 4') zumindest ein Auftrag (5) aus einem Lötstopplack aufgebracht wird.

2. Verfahren nach Anspruch 1, **dadurch gekennzeichnet, daß** Hochtemperatur-Bonding bei einer Temperatur größer 650°C durchgeführt wird, und/oder
daß Hochtemperatur-Bonding ein Direct-Bonding- oder ein Aktiv-Löt-Verfahren Verfahren ist.

3. Verfahren nach Anspruch 1 oder 2, **dadurch gekennzeichnet, daß** der wenigstens eine Auftrag (5) aus dem Lötstopplack vor dem Strukturieren aufgebracht wird.

4. Verfahren nach einem der vorhergehenden Ansprüche, **dadurch gekennzeichnet, daß** der wenigstens eine Auftrag (5) aus dem Lötstopplack nach dem Strukturieren aufgebracht wird.

5. Verfahren nach einem der vorhergehenden Ansprüche, **dadurch gekennzeichnet, daß** die Metall-Folien Kupfer-Folien sind und diese mittels des DCB-Verfahrens oder des Aktiv-Löt-Verfahrens auf dem Keramik-Substrat (2) vorgesehen werden.

6. Verfahren nach einem der vorhergehenden Ansprüche, **dadurch gekennzeichnet, daß** die Strukturierung der wenigstens einen Metall-Folie (3', 4') mittels eines Maskierungs-Ätz-Verfahrens erfolgt, und
daß das Aufbringen des wenigstens einen Auftrags (5) aus Lötstopplack unmittelbar nach diesem Strukturieren oder unmittelbar vor dem Aufbringen eines Ätzresists des Maskierungs-Ätz-Verfahrens erfolgt, erfolgt.

7. Verfahren nach einem der vorhergehenden Ansprüche, **dadurch gekennzeichnet, daß** nach dem Aufbringen des Lötstopplack-Auftrags (5) ein Abtragen des Metalls der Metallisierung zumindest in an diesen Lötstopplack-Auftrag (5) angrenzenden Oberflächenbereichen beispielsweise mit einer Dicke von 0,1 bis 20 µm erfolgt,
wobei beispielsweise das Abtragen durch Ätzen erfolgt, z.B. unter Verwendung von Wasserstoffperoxid, Natriumpersulfat, Kupferchlorid oder Eisenchlorid.

8. Verfahren nach einem der vorhergehenden Ansprüche, **dadurch gekennzeichnet, daß** vor dem Aufbringen des wenigstens einen Lötstopplack-Auftrags (5) eine Reinigung der Metallflächen, vorzugsweise durch Abtragen eines Oberflächenbereichs der Metallisierungen erfolgt,
wobei beispielsweise
das Reinigen durch chemisches Abtragen und/oder durch Plasma-Ätzen und/oder durch elektrisches Ätzen und/oder galvanisches Abtragen und/oder durch mechanische Bearbeitung, beispielsweise durch Bürsten oder Schleifen erfolgt, und
wobei beispielsweise das chemische Reinigen unter Verwendung einer Wasserstoffperoxid-Lösung oder einer Natriumpersulfat-Lösung erfolgt.

9. Verfahren nach einem der vorhergehenden Ansprüche, **dadurch gekennzeichnet, daß** auf wenigstens einen an den wenigstens einen Lötstopplack-Auftrag (5) anschließenden, vorzugsweise durch Abtragen erzeugten Oberflächenbereich (8) zumindest einer Metallisierung eine Oberflächen-Metallisierung (10) aufgebracht wird,
wobei beispielsweise das Aufbringen der Oberflächen-Metallisierung (10) derart erfolgt, daß die von dieser Oberflächen-Metallisierung gebildete Oberfläche niveaugleich oder in etwa niveaugleich mit der Oberfläche des wenigstens einen Lötstopplack-Auftrags (5) oder niveaugleich oder in etwa niveaugleich mit der unbehandelten Oberfläche unterhalb des wenigstens einen Lötstopplack-Auftrags (5) ist, und/oder
wobei beispielsweise das Aufbringen der Oberflächen-Metallisierung (10) derart erfolgt, daß die von dieser Oberflächen-Metallisierung gebildete Oberfläche über das Oberflächenniveau des wenigstens einen Lötstopplack-Auftrags (5) oder über das Oberflächenniveau der unbehandelten Oberfläche unterhalb des wenigstens einen Lötstopplack-Auftrags (5) vorsteht, und/oder
wobei beispielsweise das Aufbringen der Oberflächen-Metallisierung (10) derart erfolgt, daß die von dieser Oberflächen-Metallisierung gebildete Oberfläche etwas tiefer liegt als das Oberflächenniveau des wenigstens einen Lötstopplack-Auftrags (5) oder der unbehandelten Oberfläche unterhalb des wenigstens einen Lötstopplack-Auftrags (5).

10. Verfahren nach einem der vorhergehenden Ansprüche, **dadurch gekennzeichnet, daß** für den Lötstopplack-Auftrag ein Lack auf Epoxid-Basis verwendet wird, und daß das Aushärten des Lötstopplack-Auftrags thermisch erfolgt, und/oder daß der wenigstens eine Lötstopplack-Auftrag eine Dicke von 0,5 - 100 µm aufweist.

11. Verfahren nach einem der vorhergehenden Ansprüche, **dadurch gekennzeichnet, daß** der wenigstens eine Lötstopplack-Auftrag (5) zumindest in einem Bereich (5') zur Bildung eines optisch lesbaren Codes strukturiert wird.

## Claims

1. Method for manufacturing a metal-ceramic substrate, more particularly a copper-ceramic substrate, wherein at least one metal foil (3',4') is applied to each surface side of a ceramic layer or a ceramic substrate(2) by means of a high temperature bonding process and the metal foil (3,4) on at least one surface side is structured to form conductor paths, contact faces and the like, **characterised in that** after the high temperature bonding process at least one coating (5) of a solder resist lacquer is applied to the metal surface of at least one metal foil (3', 4') or at least a metal plating (3, 4, 3',4').

2. Method according to claim 1 **characterised in that** high temperature bonding is carried out at a temperature higher than 650°C and/or that the high temperature bonding is a direct bonding or an active soldering process.

3. Method according to claim 1 or 2 **characterised in that** the at least one coating (5) of solder resist lacquer is applied prior to structuring.

4. Method according to one of the preceding claims **characterised in that** the at least one coating (5) of solder resist lacquer is applied after structuring.

5. Method according to one of the preceding claims **characterised in that** the metal foils are copper foils and these are provided on the ceramic substrate (2) by means of the DCB process or active soldering process.

6. Method according to one of the preceding claims **characterised in that** the structuring of the at least one metal foil (3', 4') is carried out by means of a masking-etching process and that applying the at least one coating (5) of solder resist lacquer is carried out immediately after this structuring or immediately before applying an etching resist of the masking-etching process.

7. Method according to one of the preceding claims **characterised in that** after applying the solder resist coating (5) the metal of the metal plating is removed at least in surface areas adjoining this solder resist coating (5) by way of example by a depth of 0.1 to 20µm, whereby for example the gouging is carried out by etching, for example by using hydrogen peroxide, sodium persulphate, copper chloride or ferric chloride.

8. Method according to one of the preceding claims **characterised in that** before applying the at least one solder resist coating (5) the metal surfaces are cleaned, preferably by gouging a surface area of the metal plating, wherein by way of example hydrogen peroxide solution or a sodium persulphate solution is used.

9. Method according to one of the preceding claims **characterised in that** a surface metal plating (10) is applied to at least one surface area (8) of at least one metal plating which (surface area) adjoins the at least one solder resist coating (5) and is preferably produced by gouging,
wherein by way of example applying the surface metal plating (10) is carried out so that the surface area formed by this surface metal plating is level or approximately level with the surface of the at least one solder resist coating (5) or level or approximately level with the untreated surface area underneath the at least one solder resist coating (5), and/or
wherein by way of example applying the surface metal plating (10) is carried out so that the surface area formed by this surface metal plating protrudes above the surface level of the at least one solder resist coating (5) or above the surface level of the untreated surface area underneath the at least one solder resist coating (5), and/or
wherein by way of example applying the surface metal plating (10) is carried out so that the surface area formed by this surface metal plating lies somewhat deeper than the surface level of the at least one solder resist coating (5) or the untreated surface area underneath the at least one solder resist coating (5).

10. Method according to one of the preceding claims **characterised in that** an epoxide-based lacquer is used for the solder resist coating, and that the hardening of the solder resist coating is carried out thermally, and/or that the at least one solder resist coating has a thickness of 0.5 - 100 µm.

11. Method according to one of the preceding claims **characterised in that** the at least one solder resist coating (5) is structured in at least one area (5') to form an optically readable code.

## Revendications

1. Procédé de préparation d'un substrat métal - céramique, en particulier d'un substrat cuivre - céramique, dans lequel (procédé) on applique, sur les côtés de la surface d'une couche de céramique ou d'un substrat céramique (2) à l'aide d'un procédé de collage à haute température, à chaque fois au moins une feuille de métal (3', 4') et la feuille de métal (3,4) est structurée sur au moins un côté de la surface pour former des pistes conductrices, des surfaces de contact et similaires, **caractérisé en ce que**, par le procédé de collage à haute température, on applique sur la surface métallique d'au moins une feuille de métal (3', 4') ou d'au moins une métallisation (3, 4, 3', 4') au moins une couche de réserve de soudure.

2. Procédé selon la revendication 1, **caractérisé en ce que** le collage à haute température est entrepris à une température de plus de 650°C, et / ou **en ce que** le procédé de collage à haute température est un procédé de soudage direct ou de soudage actif.

3. Procédé selon la revendication 1 ou 2, **caractérisé en ce que en ce que** la au moins une couche de réserve de soudure (5) est appliquée avant la structuration.

4. Procédé selon l'une quelconque des revendications qui précèdent, **caractérisé en ce que** l'on applique au moins une couche (5) de la réserve de soudure après la structuration.

5. Procédé selon l'une quelconque des revendications qui précèdent, **caractérisé en ce que** les feuilles métalliques sont des feuilles de cuivre et sont placées sur le substrat céramique (2) par le procédé DCB (collage cuivre direct) ou le procédé de soudage actif.

6. Procédé selon l'une quelconque des revendications qui précèdent, **caractérisé en ce que** la structuration de la au moins une feuille métallique (3', 4') se fait au moyen d'un procédé de masquage - décapage et que l'application de la au moins une couche (5) de réserve de soudure a lieu immédiatement après cette structuration ou immédiatement avant l'application d'un masque de gravure du procédé de masquage - décapage.

7. Procédé selon l'une quelconque des revendications qui précèdent, **caractérisé en ce que**, après l'application de la couche (5) de réserve de soudure, a lieu un enlèvement du métal de la métallisation au moins dans une zone de surface adjacente à cette couche (5) de réserve de soudure, par exemple à une épaisseur de 0,1 à 20 µm, l'enlèvement se faisant par exemple par décapage, par exemple en utilisant du peroxyde d'hydrogène, du persulfate de sodium, du chlorure de cuivre ou du chlorure de fer.

8. Procédé selon l'une quelconque des revendications qui précèdent, **caractérisé en ce que**, avant l'application de la au moins une couche (5) de réserve de soudure, a lieu un nettoyage des surfaces métalliques, de préférence par enlèvement d'une zone superficielle des métallisations, où par exemple le nettoyage est réalisé par enlèvement chimique et / ou décapage au plasma et / ou décapage électrique et / ou décapage galvanique et / ou usinage mécanique, par exemple par brossage ou meulage, et où par exemple le nettoyage chimique se fait en utilisant une solution de peroxyde d'hydrogène ou une solution de persulfate de sodium.

9. Procédé selon l'une quelconque des revendications qui précèdent, **caractérisé en ce que** l'on applique une métallisation de surface (10) sur au moins une zone de surface (8), de préférence produite par enlèvement, d'une métallisation, et adjacente à la au moins une couche (5) de réserve de soudure, où par exemple l'application de la métallisation superficielle (10) est entreprise de manière que la surface formée par cette métallisation superficielle soit au même niveau ou pratiquement au même niveau que la au moins une couche (5) de réserve de soudure ou soit au même niveau ou pratiquement au même niveau que la surface non traitée sous la au moins une couche (5) de réserve de soudure, et / ou par exemple l'application de la métallisation superficielle (10) est entreprise de manière que la surface formée par cette métallisation de surface dépasse du niveau de surface de la au moins une couche (5) de métallisation superficielle et du niveau de surface de la surface non traitée sous la au moins une couche (5) de réserve de soudure, et / ou par exemple l'application de la métallisation superficielle (10) est entreprise de manière que la surface formée par cette métallisation de surface se trouve un peu plus bas que le niveau de surface de la au moins une couche (5) de réserve de soudure ou de la surface non traitée sous la au moins une couche (5) de réserve de soudure.

10. Procédé selon l'une quelconque des revendications qui précèdent, **caractérisé en ce que** l'on utilise pour l'application de la réserve de soudure une laque à base d'époxy, et que le durcissement de la couche de réserve de soudure est réalisé par voie thermique, et . ou que la au moins une couche de réserve de soudure présente une épaisseur de 0,5 à 100 µm.

11. Procédé selon l'une quelconque des revendications qui précèdent, **caractérisé en ce que** la au moins une couche (5) de réserve de soudure est structurée dans au moins une zone (5') pour la formation d'un code lisible optiquement.
